# EUROPEAN PATENT SPECIFICATION

(11) **EP 1 559 801 B1**
(45) Date of publication and mention of the grant of the patent: **19.11.2008**
(21) Application number: 03794198.6
(22) Date of filing: 03.09.2003
(51) Int. Cl.: C22C 9/00, C22C 9/01, C22C 9/06, C22C 9/10, C22F 1/08, C23C 14/34, H01L 21/28, H01L 21/3205, H01L 21/3213

(54) **METALLIC MATERIAL FOR ELECTRONIC PART, ELECTRONIC PART, ELECTRONIC EQUIPMENT, METHOD OF WORKING METALLIC MATERIAL, PROCESS FOR PRODUCING ELECTRONIC PART AND ELECTRONIC OPTICAL PART**
METALLISCHES MATERIAL FÜR ELEKTRONISCHES BAUTEIL, ELEKTRONISCHES BAUTEIL, ELEKTRONISCHE EINRICHTUNG, VERFAHREN ZUR BEARBEITUNG VON METALLISCHEM MATERIAL, VERFAHREN ZUR HERSTELLUNG VON ELEKTRONISCHEM BAUTEIL UND ELEKTRONISCHES OPTISCHES BAUTEIL
MATERIAU METALLIQUE POUR PIECE ELECTRONIQUE, PIECE ELECTRONIQUE, EQUIPEMENT ELECTRONIQUE, PROCEDE DE FACONNAGE D'UN MATERIAU METALLIQUE, PROCEDE DE PRODUCTION D'UNE PIECE ELECTRONIQUE ET D'UNE PIECE OPTOELECTRONIQUE

(30) Priority: 04.09.2002 JP 2002258690
(43) Date of publication of application: 03.08.2005
(60) Divisional application: 08150197.5
(73) Proprietor: Dept Corporation, Chiyoda-ku Tokyo 100-0004 (JP)
(72) Inventor: UENO, Takashi c/o DEPT Corporation, Chiyoda-ku Tokyo 100-0004 (JP)
(74) Representative: Viering, Hans-Martin
(86) International application number: PCT/JP2003/011248
(87) International publication number: WO 2004/022803

(56) References cited:
- DE-A1- 3 734 424
- JP-A- 6 100 984
- JP-A- 6 256 909
- JP-A- 2003 243 325
- PATENT ABSTRACTS OF JAPAN vol. 2000, no. 15, 6 April 2001 (2001-04-06) -& JP 2000 349085 A (NEC CORP), 15 December 2000 (2000-12-15)

## Description

### 1.Field of the Invention

The present invention relates to an electronic component, an electronic device and an electronic optical component as well as a metallic material used for the same and a working method of the metallic material. And, more particularly, it relates to a metallic material with lower electrical resistance than that of conventional metallic alloy materials and having a heat stable and workable property as well as a widely applicable property, and an electronic component and the likes manufactured by using the metallic alloy material.

### 2.Background of the Invention

DE 37 34 424 A1 discloses a method for manufacturing a dispersion hardened cupper based alloy, wherein molybdenum of a content of 0.3 to 15 wt%, preferably 1-15 wt%, are mixed to the cupper melt.

ASM Speciality Handbook; Copper and Copper Alloys, edited by J.R. Davis, 1st printing, August 2001, pages 14-26 discloses copper alloys, such as C18000 including Cu (bal), Fe (0.15 wt%), Ni (1.3-3 wt%), Cr (0.1-0.8 wt%), Si (0.4-0.8 wt%), C81500 including Cu (bal), Si (0.15 wt%), Fe (0.1 wt%), Al (0.1 wt%); Sn (0.1 wt%), Pb (0.02 wt%), Zn (0.1 wt%), Cr (0.4-1.5 wt%), and C81540 including Cu (95.1 min), Si (0.4-0.8 wt%), Ni (2-3 wt%), Fe (0.15 wt%), Al (0.1 wt%); Sn (0.1 wt%), Pb (0.02 wt%), Zn (0.1 wt%), Cr (0.1-0.6 wt%).

In conventionally-used electronic devices and electronic components, wiring patterns and electrodes are formed by using a pure metallic material, such as Cu, Al, Ti, Mo, Ta, W and Cr, or a metallic alloy material, such as Al-Cu, Al-Cu-Si, Al-Pd, TaSi, WSi and TiN, as a material for wiring patterns, electrodes and contacts.

For instance, in a transmittable liquid crystal display element which forms a flat panel display, pure Al having a good etching property and a low electrical resistance is commonly used as a material for wiring patterns. However, since pure Al has a melting point as low as 660 °C, when used as the wiring patterns of the liquid crystal display element, defects, such as hillock and whisker, may occur during a heat-treatment in the temperatures in a range of from 300 to 500 °C, such as chemical vapor deposition( CVD) after a film forming process for wiring patterns. Nevertheless, due to pure Al having superiority of lower electrical resistance than that of other metallic materials and a complicated manufacturing method, a substitute material for pure Al has not been developed. Consequentially, in order to solve such a problem that defects occur easily at high temperatures, pure Al is sandwiched in between materials having a heat stability and having a high melting point, such as Ta, Mo, Cr and W, to form wiring patterns.

On the other hand, in semiconductor elements, pure Cu, as a substitute for pure Al, is tested and sometimes used as materials of electrodes and wiring patterns. Pure Cu shows high electrical conductivity, but has some problems when used for semiconductor elements. For instance, unless under high temperatures, wiring patterns cannot be worked by an etching process, and an chemical reaction of pure Cu with an silicone oxide film or a silicone layer causes damages to performance of the semiconductor elements.

Consequentially, if it becomes possible to obtain a new metallic material having a lower electrical resistance than that of conventional metallic materials, as well as a stable and workable property so as to use as wiring patterns and electrodes of various types of electronic component, high performance and easily manufacturable electric components will be provided.

Currently, in a transmittable liquid crystal display element, Ti, Ta, Mo, Cr and W are used as substitute for pure Al in order to prevent occurrence of defects. However, these elements have a disadvantage in their electrical resistances larger than that of pure Al, as shown in Table 1. Accordingly, in a transmittable liquid crystal display panel, with increases in its display area and in its resolution, since wire length of the wiring patterns will lengthen and also a wire width thereof will narrow, it will be difficult to drive a display panel accurately and easily. So, it is fact that there is no suitable material for wiring patterns of a transmittable liquid crystal display panel.

**( Table 1)**

| Material | Resistance (µ Ω cm) | Chemical stress | Anodic oxidation |
|---|---|---|---|
| Mo | 50 | low | impossible |
| Cr | 12.9 | slightly good | impossible |
| Ti | 55 | good | impossible |
| Ta | 13.6 | good | possible |
| Al | 2.7 | low | possible |
| Cu | 1.7 | low | impossible |
| Ag | 1.6 | slightly good | impossible |
| Au | 2.3 | good | impossible |

By the way, for a material used as wiring patterns, Au, Cu and Ag are known as a material having a lower electrical resistance than that of pure Al. Of such materials, Au has disadvantages such that its expensive cost leads to heighten manufacturing cost and its poor atmospheric corrosion resistance, poor workability in an etching process and poor workability in fining process. And, Ag has also disadvantages such that it is easy to react with chloride, sulfur and sulfide, and has poor workability in fining process and poor atmospheric corrosion resistance.

As Cu reacts easily, for example, when Cu contacts oxygen atom deposited on a substrate material, such as a Silicone oxide film on a Silicon wafer, or Cu is subjected to various types of manufacturing process carried out under an environment containing moisture and other oxygen, Cu reacts with oxygen under an environment containing atmosphere to form CuOx at a surface and a boundary of wiring patterns. The CuOx causes damage to advantageous properties of Cu, such as high electric conductivity and high thermal conductivity.

And, as an example of problems due to poor atmospheric corrosion resistance of Cu, when used for a liquid crystal display element, Cu contacts a transparent conductive film directly and reacts with oxygen at a boundary to form CuOx, which causes damage to physical stability of Cu. In order to solve such problems, a barrier layer is formed on a substrate, or Cu is sandwiched in between barrier layers, similar to the case of Al.

And, for a drive device for such liquid crystal displayelement, while a TFT ( thin film transistor) using amorphous silicon or poly crystal silicon is commonly used, a suitable material used for a drive device has not been yet developed.

In the drive device, for the purpose of simplification of production process, an electrode made of a metallic is oxidized, and a gate insulation film is formed between the oxidized electrode and a silicon active element( that is anodic oxidation).

Of materials for wiring patterns as shown in the table 1, materials capable of forming the gate insulation film are Al and Ta. Especially, Ta possibly forms an oxide insulation film with a high yield and having no defects such as pinhole. However, since Ta is a high-resistance material, it is required that electrodes are constructed of two-layer wiring patterns formed by an anode oxidation method which uses Al having a low electrical resistance, whereby an extra manufacturing step is required. In the case of the two-layer wiring patterns, the resistance of the wiring patterns is dependent on the resistance of Al.

In a semiconductor device such as DRAM, flash memory, CPU, MPU and ASIC, except for above-mentioned display devices, increases in the integration and the size of chips cause the wire width of the wiring patterns to narrow and the arrangement thereof to be complicated, whereby the wire length of the wiring patterns becomes long. Accordingly, such semiconductor device requires the wiring patterns to be formed by using a material having low electrical resistance and heat stable and workable property. Because, the narrower the wire width and the longer the wire length of the wiring patterns, the higher the electrical resistance of wiring patterns. As the result, potential drop occurs at the wiring patterns and voltage for driving the elements is lowered. Further, electric power consumption may increase, and signal transmission through the wiring patterns may be delayed.

And, as for an electronic component such as a printed writing board, a chip condenser and a relay other than the semiconductor device, Cu or Ag is used as a material for wiring patterns, electrodes and contacts. These materials have insufficient atmospheric corrosion resistance for practical use and are rarely recyclable.

In order to solve the above-mentioned problems, an object of the present invention is to provide a metallic material having lower electrical resistance than that of conventional metallic materials as well as having heat stable and workable property, manufacturing methods of electronic component, electronic devices and electronic optical components by using said metallic material, and a working method of said metallic material.

### 3.Summary of the Invention

The invention provides a metallic material according to claim 1.

In the metallic material for an electronic component according to the present invention, Mo is added to Cu so that Mo will be homogeneously mixed in a grain boundary of Cu, resulting in improvement of atmospheric corrosion resistance. Further, addition of a plurality of elements selected from the group consisting of Al, Au, Ag, Ti, Ni Co and Si makes electrical resistance of the metallic material lower. And, an increase in electrical resistance caused by addition of Mo as a second element can be controlled by addition of a third element. At this time, since a weight of the third element added to Cu is set in an amount of 0.1 to 3.0 % by weight, the atmospheric corrosion resistance can be improved. Accordingly, a metallic material for an electronic component, which has lower resistance than that of conventional metallic materials as well as heat stable and workable property can be provided.

It is confirmed that the above-mentioned metallic material has lower electrical resistance than that of conventional metallic materials and heat stable and workable property.

And, it is desirable that the metallic material for an electronic component according to the present invention has electrical resistance lower than 10 µ Ω cm.

Further, the invention provides a metallic material according to claim 3.

In the metallic material for an electronic component according to the present invention, Mo is added to Cu so that Mo will be homogeneously mixed in a grain boundary of Cu, resulting in improvement of atmospheric corrosion resistance. Further, addition of one element selected from a group consisting of Al, Au, Ag, Ti, Ni Co and Si makes electrical resistance of the metallic material lower. And, an increase in electrical resistance caused by addition of Mo as a second element can be controlled by addition of a third element. At this time, since a weight of the third element added to Cu is set in an amount of 0.1 to 3.0 % by weight, the atmospheric corrosion resistance can be improved. Accordingly, a metallic material for an electronic component, which has lower electrical resistance than that of conventional metallic materials as well as heat stable and workable property, can be provided.

And, it is desirable that the metallic material for an electronic component according to the present invention has electrical resistance higher than 1.5 µ Ω cm and lower than 7.0 µ Ω cm.

And, it is possible that the metallic material for an electronic component according to the present invention is used as a material for wiring patterns, electrodes, contacts and targets for a sputtering process.

Further, the invention provides an electronic component according to claim 6.

It is confirmed that the metallic material used for above-mentioned electronic component has lower electrical resistance than that of conventional metallic material as well as heat stable and workable property.

And, it is possible that the electronic component according to the present invention has wiring patterns, electrodes and contacts which are formed by an etching process using a solution including phosphoric acid and nitric acid.

The metallic material consisting of alloy including three or more elements used for the electronic component according to the present invention can be subjected to an etching process using phosphoric etchant, such as H₃PO4 + HNO₃ + CH₃COOH. And, an addition of phosphoric acid, nitric acid, acetic acid, water, cerium nitrate, silver nitrate to the etchant allows the etching rate to be controlled. Accordingly, a patterning process suitable for such kind of metallic material can be added to conventional pattering processes.

And, it is possible that the electronic component according to the present invention has wiring patterns, electrodes and contacts which are formed by an etching process under a gas atmosphere including chlorine.

Themetallicmaterial consisting of alloy including three or more elements used for the electronic component according to the present invention can be subjected to an dry etching process under a gas atmosphere including chlorine, for instance RIE( reactive ion etching) and a plasma etching process under a gas atmosphere including chlorine such as Cl₂, CCl₄, BCl₃ and SiCl₄. Accordingly, a patterning process suitable for such the metallic materials can be added to conventional pattering processes.

And, it is possible that the electronic component according to the present invention has region other than wiring patterns, electrodes and contacts are formed by an etching process under a gas atmosphere including fluorine.

The metallic material consisting of alloy including three or more elements used for the electronic component is advantageous in that it is hardly damaged by a gas including fluorine under the etching process. Therefore, when subjected to an etching process such as RIE and plasma etching, which are carried out under a gas atmosphere including fluorine such as CF₄, C₃F₈, C₄F₈ and SF₆ and not including chlorine, the metallic material consisting of an alloy including three or more elements is not etched and another materials such as Si, poly-crystalline Si, amorphous Si, SiO₂, Si₃N₄, Mo, W, Ta, Ti and Pt are etched. Accordingly, a patterning process available for device made of such metallic material and another materials can be provided.

And, it is possible that the electronic component according to the present invention has wiring patterns, electrodes and contacts which are formed by a heat treatment in the range of the temperatures from 100 °C to 750 °C.

And, it is possible that the electronic component according to the present invention has wiring patterns, electrodes and contacts which are formed on a backing layer made of one of Ti, W, Ta, Mo, indium tin oxide, titanium nitride, oxidation silicon and silicon nitride.

And, it is possible that the electronic component according to the present invention has wiring patterns, electrodes and contacts which are directly formed on a substrate made of one of glass or plastic resin. Because, the wiring patterns, electrodes and contacts which formed by the metallic material according to the present invention shows a sufficiently adhesion.

In the above-mentioned electronic component, the alloy consisting of CuMo alloy including mainly Cu and Mo in an amount of 0.1 to 3.0 % by weight, further including one or a plurality of elements selected from a group consisting of Al, Au, Ag, Ti, Ni Co and Si in a total amount of 0.1 to 3.0% by weight, has an excellent heat conductivity inherent for pure Cu. Also, the alloy can be subjected to a conventional deposition process such as a sputtering process, a vapor deposition process, a CVD process and a plating process, and a patterning can be easily carried out by a wet etching process and a dry etching process while its heat stability being maintained under high temperatures. Accordingly, an electronic component which uses an metallic material having a low electrical resistance and excellent properties in a heat stability and a workability, for wiring patterns, electrodes and contacts can be provided.

Further, the invention provides an electronic device according to claim 13.

It is confirmed that the above-mentioned metallic material used for the above-mentioned electronic device has lower electrical resistance than that of conventional metallic materials as well as heat stable and workable property.

Here, the electronic device means a condenser component having a certain capacitor such as a lamination chip condenser and an electrolytic condenser, a semiconductor package component which a semiconductor element is mounted( or bonded) on a cupper sheet or a plastic substrate, and a product which combined these components.

And, it is possible that the electronic device according to the present invention has wiring patterns, electrodes and contacts which are formed by an etching process using a solution including phosphoric acid and nitric acid.

And, it is possible that the electronic device according to the present invention has wiring patterns, electrodes and contacts which are formed by an etching process under a gas atmosphere including chlorine.

And, it is possible that the electronic device according to the present invention has region other than wiring patterns, electrodes and contacts, are formed by an etching process under a gas atmosphere including fluorine.

And, it is possible that the electronic device according to the present invention has wiring patterns, electrodes and contacts which are formed by a heat treatment in the range of the temperatures from 100 °C to 750 °C.

And, it is possible that the electronic device according to the present invention has wiring patterns, electrodes and contacts which are formed on a backing layer made of one of Ti, W, Ta, Mo, indium tin oxide, titanium nitride, oxidation silicon and silicon nitride.

And, it is possible that the electronic device according to the present invention has wiring patterns, electrodes and contacts which are directly formed on a substrate made of one of glass or plastic resin.

Further, the invention provides a working method according to claim 20.

Further, the invention provides a working method according to claim 21.

Further, the invention provides a working method according to claim 22.

Further, the invention provides an electronic optical compoment according to claim 23.

In the above-mentioned electronic optical component, reflective films, a wiring patterns and electrodes can be formed by a metallic film consisting of an alloy having a low electrical resistance as well as excellent properties in a heat stability, a workability and a high reflectance.

Further embodiments of the invention are described in the dependent claims.

### 4. Brief Description of the Drawings

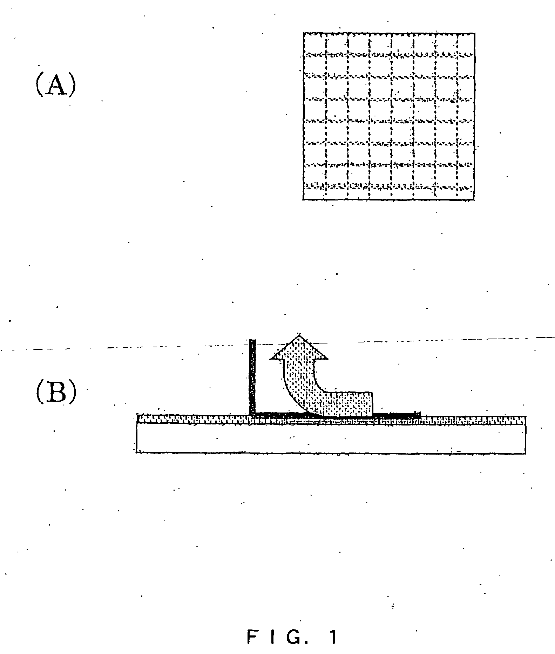

Fig. 1(A) is a plan view schematically showing a sample for evaluation in adhesion of copper alloy according to an example, and Fig.1(B) is a cross sectional drawing schematically showing a sample as shown in Fig.1(A) in the evaluation.

### 5.Detailed Description of Embodiment of the Invention

The preferred embodiments of the present invention will be described in detail.

A metallic material according to the present invention consists of an alloy including mainly Cu, Mo in an amount of 0.1 to 3.0% by weight and one or a plurality of elements selected from a group consisting of Al, Au, Ag, Ti, Ni Co and Si in a total amount of 0.1 to 3.0% by weight, and is usable as metallic parts of various types of electronic component.

Concretely, the various types of electronic component include a transparent liquid crystal display element, an organic EL ( electronic luminescence) panel, a plasma display, a display device such as an electronic optical component using a micro mirror, various types of semiconductor device, a printed writing board, a chip condenser and a relay. And, the metallic material according to the present invention is applicable for wiring patterns, electrodes, high reflective films, contacts and a target material used for a sputtering process.

In the Cu alloy, Mo is added to Cu so that Mo will be homogeneously mixed in a grain boundary of Cu, resulting in improvement of an atmospheric corrosion resistance. Here, if only Mo is added enough to satisfy atmosphere corrosion resistance, electric resistance will increase. But, by adding one or a plurality of third element selected from a group consisting of Al, Au, Ag, Ti, Ni Co and Si, electric resistance can be lower, or, increase in the electric resistance can be controlled. A suitable amount of the third element to improve atmosphere corrosion resistance is 0.1 to 3.0% by weight, but adding the third element 3.0% by weight or more will make the atmosphere corrosion resistance lower.

The metallic material according to the present invention consists of the cupper alloy so as to have atmosphere corrosion resistance as well as advantageous properties of pure Cu such as electrical conductivity and heat conductivity. Accordingly, the metallic material according to the present invention can have enhanced atmosphere corrosion resistance as well as low electrical resistance and high heat conductivity.

When wiring patterns are formed by using the metallic material according to the present invention, a selection of a kind of added element and the amount of the added element enables electrical resistance of the wiring patterns to be 7 µ Ω cm, which is required for wiring patterns.

And, when the metallic material according to the present invention is used as wiring patterns and electrodes, it is required that electrical resistance thereof is the same value as that of AlSi, which is conventionally used as wiring patterns and electrodes. The electrical resistance less than that of Cr is thought to allow the metallic material to be put in practical use. The metallic material according to the present invention has electrical resistance over 1.6 µ Ω cm, and possibly has electrical resistance lower than 3.5 µ Ω cm of AlSi alloy if required.

And, as mentioned above, with increase of the amount of the added element for improving atmosphere corrosion resistance, electrical resistance increases. But, when the amount of the added element is set in the above-mentioned range, electrical resistance can sufficiently lower less than 12.6 µ Ω cm of electrical resistance of Cr. Accordingly, the metallic material according to the present invention can have suitable electrical resistance for a material used as wiring patterns and electrodes.

And, the Cu alloy consisted the metallic material does not have a perfectly solid-solution type structure but a Cu grain boundary precipitation type structure. While an alloy having a perfectly solid-solution type structure is assumed to be physically stable, physical property of thereof is often dependent on property of a main element included in the alloy if an amount of an added element is little. That is to say, if the main element such as Cu will have disadvantage in its property, it is difficult for the alloy to solve such disadvantage perfectly.

In a recent liquid crystal display element and semiconductor element, since wire widths of wiring patterns and electrodes become finer, a material used as such wiring patterns and electrodes strongly requires mechanical strength and electric strength. By the way, in an alloy having a grain boundary precipitation type structure, it is confirmed that a strength of a main element is improved by including an added element. The Cu alloy includes an added element , whereby sufficiently mechanical strength and electrical strength can be obtained. Accordingly, the metallic material according to the present invention can have more workable, heat stable and reliable property than that of conventionally-used materials such as Al, Mo, Cr, Ti, Ta and Cu.

And, for a working method of Cu, a dry etching process using a combined gas including chlorine, and a wet etching process using an etchant such as chlorine solution or alkali solution, like NH₄OH, are known. The Cu alloy can be worked by such the etching processes, and can be subjected to various types of working process by which pure Al or Al alloy is worked conventionally.

Here, the combined chlorine gas includes Cl₂, CCl₄, BCl₃ or SiCl₄. The Cu alloy can be worked by RIE or plasma etching under atmosphere containing such the combined gas to form a film. When wiring patterns are formed by subjecting Cu to a dry etching process using the combined gas, chlorine included in the combined gas reacts with Cu during etching processing, resulting in a formation of CuCl₂ at a boundary of the wiring patterns. The CuCl₂ damages electrical conductivity and heat conductivity. On the contrary, the film formed by using the Cu alloy does not cause such reaction of Cu with chlorine.

As mentioned above, in a manufacturing process of an electrical component by using the metallic material according to the present invention, a pattering process can be carried out by an etching process under atmosphere including chlorine.

Applying a dry etching process to an alloy including three or more elements such as the Cu alloy is difficult under gas atmosphere including fluorine and not including chlorine. This gives advantage that the alloy including three or more elements is hardly damaged by the gas including fluorine and not including chlorine. Accordingly, when subjected to an etching process such as RIE and plasma etching, which carried out under gas atmosphere such as CF₄, C₃F₈, C₄F₈ or SF₆, the alloy including three or more elements is not etched, and another materials such as Si, poly-crystalline Si, amorphous Si, SiO₂, Si₃N₄, Mo, W, Ta, Ti or Pt are etched.

Accordingly, region formed by the other material than the alloy including three or more elements can be selectivity etched by an etching process under gas atmosphere including fluorine and not including chlorine. So, by using the metallic material according to the present invention, a suitable method for pattering can be obtained.

On the contrary, in a wet etching process among a manufacturing process of display such as a liquid crystal display element, pure Al is etched by using an etchant including phosphoric acid. As such etchant including phosphoric acid, a complex including phosphoric acid such as H₃PO₄ +HNO₃ +CH₃COOH is used. A conventionally-used alloy including mainly pure Cu or Cu and other one or two added elements is hardly etched by the etching process using such etchant.

Although, it is understood that the Cu alloy including mainly Cu, Mo in an amount of 0.1 to 3.0 % by weight and one or a plurality of element selected from a group consisting of Al, Au, Ag, Ti, Co and Si in a total amount of 0.1 to 3.0% by weight can be etched by using the complex including phosphoric acid. Therefore, the Cu alloy can be subjected to an etching process by utilizing a conventionally-used etching equipment for working Al. And, by adding phosphoric acid, nitric acid, acetic acid, water, cerium nitrate or hydrochloric acid copper, an etching rate can be controlled similar to a conventional process.

And, the Cu alloy can be subjected to the same post-process such as cleaning process after an etching process as pure Al and Al alloy. In addition, contamination can be eliminated compared with pure Al or Al alloy. So, the Cu alloy has workable property compared with a conventionally-used material such as Al, Mo, Cr, Ti, Ta or Cu.

And, the Cu alloy possibly forms a film easily and steadily by a conventionally-used deposition process such as sputtering process, vapor process, CVD process and plating process. In the sputtering process, the Cu alloy can be sputtered at about 2.3 to 2.5 times faster than a material including Al. So, the Cu alloy is characterized in its fast sputtering rate. Therefore, a film forming time can be shortened and a total manufacturing time also can be shortened.

After a film is formed by a sputtering process or a vapor process, a heat-treatment process is required for alloying. The heat-treatment process is carried out in the temperatures in a range of 100 °C to 750 °C. By the heat-treatment process, a metallic film having low electric resistance as well as heat stable and workable property can be provided.

And, a working process requires sufficiently adhesion of the Cu alloy to an under layer. The Cu alloy can have satisfactory adhesion by using the under layer made of one of Ti, W, Ta, Mo, indium tin oxide, titanium nitride, oxidation silicon or silicon nitride so as to be possibly used as wiring patterns of various types of semiconductor elements in place of Al. Accordingly, the wiring patterns can have reliability.

If a material including Al is directly deposited on a plastic substrate or glass substrate to form a film, because of reaction of Al with oxygen, electric resistance of the film becomes larger as 2 to 3 times as that of a bulk material. And, if pure Ag or Ag alloy is directly deposited on a plastic substrate or a glass substrate to form a film, an adhesion of the film to the substrate is so insufficient that the film peels off the substrate easily just after the film formation, or, at a post-process.

On the contrary, since the Cu alloy hardly reacts with oxygen, when directly deposited on a plastic substrate or a glass substrate to form a film, increase in electrical resistance of the film can be prevented. In addition, because of satisfactory adhesion of the film to the substrate, peeling off or chipping after the film formation dose not occur. Accordingly, it becomes possible that the Cu alloy is directly deposited on a plastic or a glass to form wiring patterns. And, the wiring patterns have low electric resistance and can be formed by a simple producing process.

And, in a transmittable liquid crystal display panel, when wiring patterns thereof are formed by using the Cu alloy, even if wire length of wiring patterns is lengthened and narrow as its display area and its integration increase, the display panel can be easily and accurately driven. Accordingly, a transmittable liquid crystal panel having reliability and requiring little electric power can be provided.

And, in a reflective liquid crystal display panel, when wiring patterns thereof are formed by using the Cu alloy, the same effect as the transmittable liquid crystal panel can be obtained. In addition, a high reflective films formed by using the Cu alloy allows high reflectance, whereby a display area of the reflective liquid crystal display will be brightened.

And, when reflective films, electrodes and wiring patterns of an optical modulator such as an electric optical components using micro mirrors are formed by using the Cu alloy, high reflective films, electrodes and wiring patterns with low electrical resistance can be formed. So, a device having high brightness and capable of high-speed operation can be provided.

And, in these liquid crystal display panels and semiconductor devices, when the Cu alloy is subjected to an anode oxidation to form a double layer structure consisting of the Cu alloy and Ta, resulting in sufficiently low electrical resistance.

And, in various types of semiconductor device, when wiring patterns are formed by using the Cu alloy, even if the wire of the wires of the wiring patterns are lengthen and narrowed, an increase in electrical resistance is prevented so that electrical power consumption can be lowered. And also, potential drop at the wiring patterns and signal delay can be prevented. So, various types of semiconductor devices having reliability can be provided.

And, when wiring patterns on a printed writing board, electrodes of chip component and contacts of a relay are formed by using the Cu alloy, various types of products having reliability can be provided.

Next, a method and result for evaluation of adhesion of a Cu alloy of which the metallic material according to the present invention consists will be explained. Evaluation method of adhesion

First, as a sample of the Cu alloy, the following three alloys were prepared; a Cu alloy including Mo in an amount of 1.8% by weight, a Cu alloy including Mo in an amount of 1.8% by weight and Al in an amount of 1.5% by weight, and a Cu alloy including Mo in an amount of 1.8% by weight and Ag in an amount of 1.2% by weight. By using the alloy samples, film samples were prepared in the following manner. Each of the alloy samples was deposited on three kinds of substrates to form a film with a thickness of 250 nm by a magnetron sputtering method respectively. The substrate included a glass substrate, an indium oxide tin film with a thickness of 200nm and a silicon oxide film with a thickness of 500 nm. Then, total nine film samples formed by using the Cu alloys were prepared.

Second, each of the film samples was cut into a plurality of gridironed pieces as shown in Fig.1(A) by using a cutter knife. A size of the gridironed piece was about 1mm * 1mm.

Then, as shown in Fig.1(B), a tape( trade mark CT405A-18 manufactured by Nichiban Co., Ltd.) was adhered on each of the film samples of the Cu alloy, and then peeled off, thereby to examine whether or not the gridironed pieces were peeled off the substrate with the tape. As a result, none of the films was peeled off.

For comparison, each of sample films which formed by Cu, Al, Ag, Au and an AgPd alloy was examined by the same method as the Cu alloy. As a result, in the Al film, some gridironed pieces thereof were locally peeled off, and almost of all gridironed pieces of other films were peeled off or defected.

### Conclusion

It was confirmed that an adhesion of the each film formed by using the Cu alloy according to the present invention, to various types of substrates such as a glass substrate, an indium oxide tin film and a silicon oxide film, was very strong. While an AlNd alloy of which Nd is added to Al has been used as a gate electrode of a liquid crystal display element commonly, the results of the above-mentioned evaluations show that the Cu alloy can be used as an electrode having low electrical resistance as a substitute for the AlNd alloy.

Until now, a metallic material, such as pure Cu, Ag and Au, having lower electrical resistance than that of Al had not been considered to utilize as a gate electrode to which a glass substrate or an indium oxide tin was directly contacted because of insufficient adhesion of the metallic material to a glass substrate or an indium oxide tin.

Next, an evaluation for environment resistance of the Cu alloy according to the present invention will be explained.

### Evaluation for heat stability after a heat treatment in high temperatures environment

First, the following material samples were prepared; pure Al, pure Cu, pure Au, a Cu alloy including Mo in an amount of 1.8% by weight( a CuMo alloy), a Cu alloy including Mo in an amount of 1.8% by weight and Al in an amount of 1.5% by weight( a CuMoAl alloy) and a Cu alloy including Mo in an amount of 1.8% by weight and Ag in an amount of 1.2% by weight ( a CuMoAg alloy). By using the material samples, film samples were prepared in the following manner. Each of the material samples was deposited on a glass substrate to form a film with a thickness of 250 nm respectively. As for pure Cu and pure Au, each of the material samples was deposited on an adhesion layer made of Cr with a thickness of 100 nm, wherein the adhesion layer was formed on the glass substrate. Then, a pure Cu film, a pure Al film, a pure Au film, a CuMo alloy film, a CuMoAl film and a CuMoAg film were prepared.

Second, each of the aforesaid films was set in a vacuum furnace, an atmosphere furnace and a nitrogen atmosphere furnace respectively, and after heated to 100 °C, further heated to 800 °C. And, changes of the film samples were observed every 100 °C.

Then, after heating up to 800 °C, the samples was left to cool down up to room temperature( 27 °C).

### Result

The pure Al films set in all the furnaces showed white turbidness over 200°C. And, since all films melted locally over 700 °C, it could not be heated up to 800 °C.

The pure Ag films set in all the furnaces showed white turbidness over 300 °C.

The pure Au films set in all the furnaces showed turbidness over 400 °C.

The pure Cu film set in the atmosphere furnace was oxidized to blacken over 300 °C and its surface showed powdered condition over 700 °C. And, the pure Cu films set in another furnace were oxidized at their surfaces over 700 °C.

On the contrary, the CuMo alloy film set in the atmosphere furnace and the CuMoAg alloy film set in the atmosphere furnace were oxidized over 500 °C, and another film set in other furnaces did not change up to 800 °C.

The CuMoAl alloy film set in all the furnaces had not changed up to 800 °C.

The reason why the film showed turbidness is as follows. In the case the pure Al film, an oxide film is generated on its surface, and particles included in the film are bonded each other and grown by heat, resulting in an irregularly and uneven surface which causes turbidness.

### Conclusion

As the result shows, the Cu alloy according to the present invention has higher heat stability than other metallic materials having low electrical resistance. Also, since particle growing is not substantially observed, it is confirmed that the Cu alloy has heat stability.

### Evaluation for accelerated environment resistance

First, the following material samples were prepared; pure Al, pure Cu, pure Au, a Cu alloy including Mo in an amount of 1.8% by weight( a CuMo alloy), a Cu alloy including Mo in an amount of 1.8% by weight and Al in an amount of 1.5% by weight( a CuMoAl alloy) and a Cu alloy including Mo in an amount of 1.8% by weight and Ag in an amount of 1.2% by weight ( a CuMoAg alloy). By using the material samples, film samples were prepared in the following manner. Each of the material samples was deposited on a glass substrate to form a film with a thickness of 250 nm respectively. As for pure Cu and pure Au, each of the material samples was deposited on an adhesion layer made of Cr with a thickness of 100 nm, wherein the adhesion layer was formed on the glass substrate. Then, as film samples, a pure Al film, a pure Cu film, a pure Au film, a CuMo alloy film, a CuMoAl film and a CuMoAg film were prepared.

Second, each of the film samples was set in a container at a temperature of 80 °C and a humidity of 85% and left for 100 hours or more, up to 800 hours. And, each of changes of the films was observed every 100 hours.

Next, after observing all the films every 100 hours up to 800 hours, all the films retrieved from the container.

### Result

The pure Al film was oxidized to show white turbidness at its surface after 200 hours, and showed black spots locally after 700 hours, resulting in an appearance of white turbidness and loss in metallic luster.

The pure Ag film began to blacken after 300 hours, and changed in yellowy black color at its all surface after 800 hours, resulting in loss in metallic luster.

The pure Au film showed black spots locally at its surface after 800 hours. But, obviously changes in its surface were hardly observed and metallic luster was maintained.

The pure Cu film began to blacken at its surface before 100 hours, and blackened at its all surface after 400 hours.

On the contrary, the CuMo alloy film and the CuMoAg alloy film hardly changed until 800 hours like the pure Au film, but showed black spots locally at its surface and thinner metallic luster.

The CuMoAl alloy film did not change, and its metallic luster was kept perfectly.

### Conclusion

According to the evaluation for accelerated environment resistance, all of the Cu alloys have corrosion resistance like Au and superior atmosphere resistance to Al or Ag. Evaluation for chemical resistance by immersing in solution

First, the following material samples were prepared; pure Al, pure Cu, pure Au, a Cu alloy including Mo in an amount of 1.8% by weight( a CuMo alloy), a Cu alloy including Mo in an amount of 1.8% by weight and Al in an amount of 1.5% by weight( a CuMoAl alloy) and a Cu alloy including Mo in an amount of 1.8% by weight and Ag in an amount of 1.2% by weight ( a CuMoAg alloy). By using the material samples, film samples were prepared in the following manner. Each of the material samples was deposited on a glass substrate to form a film with a thickness of 250 nm respectively. As for pure Cu and pure Au, each of the material samples was deposited on an adhesion layer made of Cr with a thickness of 100 nm, wherein the adhesion layer was formed on the glass substrate. Then, as film samples, a pure Al film, a pure Cu film, a pure Au film, a CuMo alloy film, a CuMoAl film and a CuMoAg film were prepared.

Second, each of the film samples were immersed in a 3% NaCl solution, a 5% NaOH solution, a 1% KOH solution and a 1% H₂SO₄ solution respectively, and then left to stand at room temperature for 100 hours. And, changes of the samples were observed after 24-hour and 100-hour immersions.

In addition, after 100 hours, all the films were picked from each solution and washed by purified water, and each change of the films before and after immersion was observed.

### Result

The pure Al films were oxidized to show white turbidness at its surface and loss in metallic luster in a fewminutes soon after the immersion began. Further more, before 100 hours, the films became translucent, and a rapid chemical reaction was occurred.

The pure Ag film immersed in the 3% NaCl solution showed white turbidness after 30 minutes, and the pure Ag film immersed in the 1% H₂SO₄ solution blackened. And, the pure Ag films immersed in the other solution showed loss in metallic luster. And, all the films became translucent or melted or blackened after 24 hours. Conditions of all the films changed.

The pure Au film did not change up to 24-hour immersion by visual observation, and after 100 hours all films showed black turbidness or become translucent.

The pure Cu films blackened in a few minutes soon after the immersion began, and after 100 hours blackened perfectly.

On the contrary, the CuMo alloy film, the CuMoAg alloy film and the CuMoAl alloy film hardly changed, except black spots shown locally.

### Conclusion

Al, Ag and Cu, which are conventionally used materials, reacted chemically to show loss in metallic luster, white turbdiness, blackening or translucence. That is to say, these materials are easily influenced or significantly changes over time by high temperatures and high humidity environments or chemicals, suggesting that these materials have little physical stability.

On the contrary, the three kinds of Cu alloys, which consist of mainly pure Cu and an added element such as Mo, Al or Ag in an amount of 0.1% by weight, have enhanced heat resistances, high-temperature and high-humidity environment resistance and chemical resistance. In other words, addition of Mo, Al or Ag to pure Cu in a small amount will dramatically improve physical instability of pure Cu.

Moreover, by increasing each amount of added elements, Mo, Al or Ag, heat resistances, high-temperature and high-humidity environment resistance and chemical resistance of the Cu alloy will be further improved.

Accordingly, since the Cu alloys are stable even at a high temperature of about 750 °C, it is not required to form a protective film after forming a film by using the Cu alloy. So, a post heat-treatment process after the film formation can be simplified.

And, since the Cu alloys are stable under high temperature and humidity environments, wiring patterns formed by using the Cu alloy will be reliable.

Table 2 shows a measurement for chemical resistance in photolithography. First, film sample was prepared in the following manner. A Cu alloy including Mo in an amount of 1.0% by weight and Al in an amount of 1.0% by weight is deposited on a silicone substrate to form a film having a thickness of 150 nm. And, the film was subjected to a development process in a lithography process, and after baking, the electrical resistance of the film was measured.

**(Table 2)**

| Condition | After film forming | After immersion in a 5% silicic acid sodium and a 3% phosphoric acid hydrogen disodium solution( element of developer) | Baking for 30 minutes at a temperature 87 °C ) (resist baking) |
|---|---|---|---|
| Electrical resistance( Ω /□) | 0.2 Ω/□ | 0.2 Ω/□ | 0.2 Ω/□ |

In the develop process, the film was immersed in a 5% silicic acid sodium and 3% phosphoric acid hydrogen disodium solution, which are main elements of the developer. And, in the baking process, the film on which to coat a resist was baked for 30 minutes at a temperature of 87 °C.

### Evaluation for plasma ashing resistance

Al and Al alloy, or, Cu, Ag and their alloys, which conventionally tested as a substitute material having low electrical resistance for Al and Al alloys, are used for wiring patterns and electrodes. However, since such materials do not have sufficient resistance in an oxygen plasma ashing carried out after an etching process for wiring patterns, the plasma ashing process requires specific operating conditions.

The plasma ashing process is an important process to improve reliability of single-layered wiring patterns and electrodes when the wiring patterns and electrodes are formed by a plurality of layers. In the ashing process, a mixed gas, in which oxygen and argon are mixed at a specific flow rate, is splayed on wiring patterns and electrodes by using plasma. As a result, contamination and moisture on an upper surface of the wiring patterns and electrode are removed, and particles present at a grain boundary of wiring patterns and electrodes are removed. However, since conventionally-used materials having low electrical resistance are instable for oxygen plasma, the plasma ashing process requires specific operation condition. Consequently, materials for end products will not be sufficiently reliable, or, to provide higher integrated wiring patterns will be difficult.

Accordingly, whether or not the Cu alloy according to the present invention has higher resistance for a plasma ashing process than that of Al, Al alloy Cu and Al is examined by the following method.

First, the following material samples were prepared; pure Al, pure Cu, pure Au, CuMo alloy, CuMoAl alloy and CuMoAg alloy. And, each of these samples was deposited on each of a glass substrate to form a film with a thickness of 250 nm. As for pure Cu and pure Au, Cr is deposited on the glass substrate to form an adhesion layer with a thickness of 100 nm. Then, a pure Al film, a pure Cu film, a pure Au film, a CuMo alloy film, a CuMoAl film and a CuMoAg film were prepared.

Second, these film samples were set in an ashing device and subjected to a plasma ashing process in the following condition: RF power is 500 W; ashing gas is a mixed gas of oxygen with argon ( mixing ration is 50 : 50 % by volume); flow rate is 5 ml/m; °C of vacuum is 1.0 to 1.5 torr during the ashing process; ashing time is 300 seconds ( 5 minutes). The temperature on the surface of the substrate is about 160 °C by measurement using thermo couple.

After the plasma ashing process, the plasma ashing device left without being opened for 20 minutes to cool down. Then, the samples were retrieved from the device and the surfaces thereof were visually observed. Further, the electrical resistance of each of the films was measured by using a four-prove method.

### Result

The pure Al film blackened at its surface and lost its metallic luster. And, the surface electrical resistance thereof was too high to measure.

The pure Ag film blackened at its surface and its surface showed powdered condition, then peeled off. Its electrical resistance could not be measured.

The pure Cu film blackened at its surface and its surface showed powdered condition, then peeled off. Its electrical resistance could not be measured.

On the contrary, the CuMo alloy film, the CuMoAg alloy film and the CuMoAl alloy film did not change in metallic luster or color before and after the plasma ashing process. Also, the electrical resistance thereof did not change.

### Conclusion

In a recent liquid crystal display element and semiconductor element which requires high integrated wiring patterns consisting of fine wires, Al, or, Ag and Cu having low electrical resistance are used for a material for wiring patterns. However, it has been problem that such materials are insufficient in resistance for an oxygen plasma ashing process.

Since such problems have not been solved sufficiently up to now, the plasma ashing process requires currently specific operating conditions.

On the contrary, the Cu alloy according to the present invention can be subjected to a plasma ashing process without physical change or deterioration thereof. Accordingly, wiring patterns and electrodes formed by the Cu alloy according to the present invention can have higher reliability than that of conventionally used materials, and can be manufactured easily by a conventionally way.

Table 3 shows an evaluation for film forming rate by a DC magnetron sputtering method.

A method for the evaluation is explained. Each Cu alloys shown in Table 3 was used as a sputtering target material with a diameter of 8 inch. And, a substrate was arranged apart from the sputtering target at a distance of 120 mm, and then, the Cu alloy was sputtered on the substrate to form a film. And, a time duration until a thickness of the film become 120 nm was measured.

**(Table 3)**

| Material | Power( W) | Time( second) | Film thickness(nm) |
|---|---|---|---|
| CuMo | 300 | 140 | 120 |
| CuMoAl | 300 | 141 | 120 |
| CuMoAg | 300 | 140 | 120 |
| Cu | 300 | 135 | 120 |
| Al | 300 | 314 | 120 |

As a result of the evaluation, each of target materials formed by the CuMO alloy, the CuMoAl alloy and the CuMoAg alloy has a film formation rate of 2.3 to 2.5 times faster than that of Al. Accordingly, when the Cu alloy according to the present invention is used in the place of Al, a film formation time can be reduced to half and also a manufacturing time can be reduced.

In addition, a film formation rate of the Cu alloy is faster than that of pure Cu. And, since a temperature rise of the substrate on which the Cu alloy was deposited was smaller than that of conventionally-used materials, plastic material can be used as a substrate.

And, a film formation process does not only refer to a sputtering process but also to refer to another film formation process and a thick film formation process.

## Claims

1. A metallic material for an electronic component, said metallic material consisting of an alloy including mainly Cu and having a composition of Mo in an amount of 0.1 to 3.0% by weight, a plurality of elements selected from a group consisting of Al, Au, Ag, Ti, Ni, Co and Si in a total amount of 0.1 to 3.0% by weight and Cu as a remaining content.

2. The metallic material for an electronic component according to claim 1, said metallic material having electrical resistance lower than 10 µΩ cm.

3. A metallic material for an electronic component, said metallic material consisting of a ternary alloy including mainly of Cu, Mo in an amount of 0.1 to 3.0% by weight and one element selected from a group consisting of Al, Au, Ag, Ti, Ni, Co and Si in an amount of 0.1 to 3.0% by weight.

4. The metallic material for an electronic component according to claim 3, said metallic material having electrical resistance higher than 1.5 µΩ cm and lower than 7.0 µΩ cm.

5. The metallic material for an electronic component according to claim 1, said metallic material being used as a material for wiring patterns, electrodes, contacts and targets for a sputtering process.

6. An electronic component having wiring patterns, electrodes and contacts using a metallic material, said metallic material consisting of an alloy including mainly Cu and having a composition of Mo in an amount of 0.1 to 3.0% by weight, one or a plurality of elements selected from a group consisting of Al, Au, Ag, Ti, Ni, Co and Si in a total amount of 0.1 to 3.0% by weight and Cu as a remaining content.

7. The electronic component according to claim 6, said electrical component having wiring patterns, electrodes and contacts which are formed by an etching process using a solution including phosphoric acid and nitric acid.

8. The electronic component according to claim 6, said electronic component having wiring patterns, electrodes and contacts which are formed by an etching process under a gas atmosphere including chlorine.

9. The electronic component according to one of claims 6 to 8, said electronic component having region other than wiring patterns, electrodes and contacts are formed by an etching process under a gas atmosphere including fluorine.

10. The electronic component according to one of claims 6 to 9, said electronic component having wiring patterns, electrodes and contacts which are formed by a heat treatment in the range of the temperatures from 100°C to 750°C.

11. The electronic component according to one of claims 6 to 10, said electronic components having wiring patterns, electrodes and contacts which are formed on a backing layer made of one of Ti, W, Ta, Mo, indium tin oxide, titanium nitride, oxidation silicon and silicon nitride.

12. The electronic component according to one of claims 6 to 10, said electronic component having wiring patterns, electrodes and contacts which are directly formed on a substrate made of one of glass or plastic resin.

13. An electronic device having wiring patterns, electrodes and contacts using a metallic material, said metallic material consisting of an alloy including mainly Cu and having a composition of Mo in an amount of 0.1 to 3.0% by weight, one or a plurality of elements selected from a group consisting of Al, Au, Ag, Ti, Ni, Co and Si in a total amount of 0.1 to 3.0% by weight and Cu as a remaining content.

14. The electronic device according to claim 13, said electronic device having wiring patterns, electrodes and contacts which are formed by an etching process using a solution including phosphoric acid and nitric acid.

15. The electronic device according to claim 13, said electronic device having wiring patterns, electrodes and contacts which are formed by an etching process under a gas atmosphere including chlorine.

16. The electronic device according to claim 13, said electronic device having region other than wiring patterns, electrodes and contacts, are formed by an etching process under a gas atmosphere including fluorine.

17. The electronic device according to one of claims 13 to 16, said electronic device having wiring patterns, electrodes and contacts which are formed by a heat treatment in the range of the temperatures from 100°C to 750°C.

18. The electronic device according to one of claims 13 to 17, said electronic device having wiring patterns, electrodes and contacts which are formed on a backing layer made of one of Ti, W, Ta, Mo, indium tin oxide, titanium nitride, oxidation silicon and silicon nitride.

19. The electronic device according to one of claims 13 to 17, said electronic device having wiring patterns, electrodes and contacts which are directly formed on a substrate made of one of glass or plastic resin.

20. A working method of a metallic material, in which a metallic film consisting of an alloy including mainly Cu, said metallic film consisting of an alloy having a composition of Mo in an amount of 0.1 to 3.0% by weight, one or a plurality of elements selected from a group consisting of Al, Au, Ag, Ti, Ni, Co and Si in a total amount of 0.1 to 3.0% by weight and Cu as a remaining content, is etched by using a solution including phosphoric acid and nitric acid to form wiring patterns, electrodes and contacts.

21. A working method of a metallic material, in which a metallic film consisting of an alloy including mainly Cu, said metallic material consisting of an alloy having a composition of Mo in an amount of 0.1 to 3.0% by weight, one or a plurality of elements selected from a group consisting of Al, Au, Ag, Ti, Ni, Co and Si in a total amount of 0.1 to 3.0% by weight and Cu as a remaining content, is etched under a gas atmosphere including hydrochloric acid to form wiring patterns, electrodes and contacts.

22. A manufacturing method of electronic component, in which a metallic film is consisted of an alloy including mainly Cu and having a composition of Mo in an amount of 0.1 to 3.0% by weight, one or a plurality of elements selected from a group consisting of Al, Au, Ag, Ti, Ni, Co and Si in a total amount of 0.1 to 3.0% by weight and Cu as a remaining content, and a film other than said metallic film is worked by an etching process under a gas atmosphere including fluorine.

23. An electronic optical component having reflective films, electrodes and wiring patterns which are formed by a metallic film consisting of an alloy including mainly Cu, said metallic film consisting of an alloy having a content of Mo in an amount of 0.1 to 3.0% by weight, one or a plurality of elements selected from a group consisting of Al, Au, Ag, Ti, Ni, Co and Si in a total amount of 0.1 to 3.0% by weight and Cu as a remaining content.

## Patentansprüche

1. Ein metallisches Material für eine elektronische Komponente, wobei das metallische Material aus einer hauptsächlich Cu umfassenden Legierung besteht, welche eine Zusammensetzung aus Mo in einer Menge von 0,1 bis 3,0 Gew.-%, mehreren Elementen, ausgewählt aus der aus Al, Au, Ag, Ti, Ni, Co und Si bestehenden Gruppe, in einer Gesamtmenge von 0,1 bis 3,0 Gew.-% und Cu als Restgehalt besitzt.

2. Das metallische Material für eine elektronische Komponente gemäß Anspruch 1, wobei das metallische Material einen elektrischen Widerstand von weniger als 10 µΩ cm hat.

3. Ein metallisches Material für eine elektronische Komponente, wobei das metallische Material aus einer ternären Legierung besteht, die hauptsächlich Cu, Mo in einer Menge von 0,1 bis 3,0 Gew.-% und ein Element, ausgewählt aus der aus Al, Au, Ag, Ti, Ni, Co und Si bestehenden Gruppe in einer Menge von 0,1 bis 3,0 Gew.-% umfasst.

4. Das metallische Material für eine elektronische Komponente gemäß Anspruch 3, wobei das metallische Material einen elektrischen Widerstand von mehr als 1,5 µΩ cm und geringer als 7,0 µΩ cm hat.

5. Das metallische Material für eine elektronische Komponente gemäß Anspruch 1, wobei das metallische Material als ein Material für Leitungsmuster, Elektroden, Kontakte und Targets für Sputterprozesse eingesetzt wird.

6. Eine elektronische Komponente mit Leitungsmustern, Elektroden und Kontakten, in denen ein metallisches Material eingesetzt ist, wobei das metallische Material aus einer hauptsächlich Cu umfassenden Legierung besteht, welche eine Zusammensetzung aus Mo in einer Menge von 0,1 bis 3,0 Gew.-%, einem oder mehreren Elementen, ausgewählt aus der aus Al, Au, Ag, Ti, Ni, Co und Si bestehenden Gruppe, in einer Gesamtmenge von 0,1 bis 3,0 Gew.-% und Cu als Restgehalt besitzt.

7. Die elektronische Komponente gemäß Anspruch 6, wobei die elektronische Komponente Leitungsmuster, Elektroden und Kontakte aufweist, welche durch einen Ätzprozess unter Verwendung einer Phosphorsäure und Salpetersäure umfassenden Lösung erzeugt sind.

8. Die elektronische Komponente gemäß Anspruch 6, wobei die elektronische Komponente Leitungsmuster, Elektroden und Kontakte aufweist, welche durch einen Ätzprozess unter einer Chlor umfassenden Gasatmosphäre erzeugt sind.

9. Die elektronische Komponente gemäß einem der Ansprüche 6 bis 8, wobei die elektronische Komponente einen anderen Bereich als Leitungsmuster, Elektroden und Kontakte aufweist, welcher durch einen Ätzprozess unter einer Fluor umfassenden Gasatmosphäre erzeugt ist.

10. Die elektronische Komponente gemäß einem der Ansprüche 6 bis 9, wobei die elektronische Komponente Leitungsmuster, Elektroden und Kontakte aufweist, welche durch eine Wärmebehandlung im Temperaturbereich von 100°C bis 750°C erzeugt sind.

11. Die elektronische Komponente gemäß einem der Ansprüche 6 bis 10, wobei die elektronischen Komponenten Leitungsmuster, Elektroden und Kontakte aufweisen, welche auf einer Verstärkungsschicht erzeugt sind, die aus einem aus Ti, W, Ta, Mo, Indiumzinnoxid, Titannitrid, oxidiertem Silizium und Siliziumnitrid hergestellt ist.

12. Die elektronische Komponente gemäß einem der Ansprüche 6 bis 10, wobei die elektronische Komponente Leitungsmuster, Elektroden und Kontakte aufweist, welche direkt auf einem aus Glas oder Kunststoffharz hergestellten Substrat erzeugt sind.

13. Eine elektronische Vorrichtung mit Leitungsmustern, Elektroden und Kontakten, in denen ein metallisches Material eingesetzt ist, wobei das metallische Material aus einer hauptsächlich Cu umfassenden Legierung besteht, welche eine Zusammensetzung aus Mo in einer Menge von 0,1 bis 3,0 Gew.-%, einem oder mehreren Elementen, ausgewählt aus der aus Al, Au, Ag, Ti, Ni, Co und Si bestehenden Gruppe, in einer Gesamtmenge von 0,1 bis 3,0 Gew.-% und Cu als Restgehalt besitzt.

14. Die elektronische Vorrichtung gemäß Anspruch 13, wobei die elektronische Vorrichtung Leitungsmuster, Elektroden und Kontakte aufweist, die durch einen Ätzprozess unter Verwendung einer Phosphorsäure und Salpetersäure umfassenden Lösung erzeugt sind.

15. Die elektronische Vorrichtung gemäß Anspruch 13, wobei die elektronische Vorrichtung Leitungsmuster, Elektroden und Kontakte aufweist, welche durch einen Ätzprozess unter einer Chlor umfassenden Gasatmosphäre erzeugt sind.

16. Die elektronische Vorrichtung gemäß Anspruch 13, wobei die elektronische Vorrichtung einen anderen Bereich als Leitungsmuster, Elektroden und Kontakte aufweist, die durch einen Ätzprozess unter Verwendung einer Fluor umfassenden Gasatmosphäre erzeugt sind.

17. Die elektronische Vorrichtung gemäß einem der Ansprüche 13 bis 16, wobei die elektronische Vorrichtung Leitungsmuster, Elektroden und Kontakte aufweist, welche durch eine Wärmebehandlung im Temperaturbereich von 100°C bis 750°C erzeugt sind.

18. Die elektronische Vorrichtung gemäß einem der Ansprüche 13 bis 17, wobei die elektronische Vorrichtung Leitungsmuster, Elektroden und Kontakte aufweist, welche auf einer Verstärkungsschicht erzeugt sind, die aus einem aus Ti, W, Ta, Mo, Indiumzinnoxid, Titannitrid, oxidiertem Silizium und Siliziumnitrid hergestellt ist.

19. Die elektronische Vorrichtung gemäß einem der Ansprüche 13 bis 17, wobei die elektronische Vorrichtung Leitungsmuster, Elektroden und Kontakte aufweist, welche direkt auf einem aus Glas oder Kunststoffharz hergestellten Substrat erzeugt sind.

20. Ein Arbeitsverfahren für ein metallisches Material, in welchem ein metallischer Film, bestehend aus einer hauptsächlich Cu umfassenden Legierung, wobei der metallische Film aus einer Legierung mit einer Zusammensetzung aus Mo in einer Menge von 0,1 bis 3,0 Gew.-%, einem oder mehreren Elementen, ausgewählt aus einer aus Al, Au, Ag, Ti, Ni, Co und Si bestehenden Gruppe, in einer Gesamtmenge von 0,1 bis 3,0 Gew.-% und Cu als Restgehalt besteht, unter Verwendung einer Phosphorsäure und Salpetersäure umfassenden Lösung geätzt wird, um Leitungsmuster, Elektroden und Kontakte zu erzeugen.

21. Ein Arbeitsverfahren für ein metallisches Material, in welchem ein metallischer Film, bestehend aus einer hauptsächlich Cu umfassenden Legierung, wobei das metallische Material aus einer Legierung mit einer Zusammensetzung aus Mo in einer Menge von 0,1 bis 3,0 Gew.-%, einem oder mehreren Elementen, ausgewählt aus einer aus Al, Au, Ag, Ti, Ni, Co und Si bestehenden Gruppe, in einer Gesamtmenge von 0,1 bis 3,0 Gew.-% und Cu als Restgehalt besteht, unter einer Salzsäure umfassenden Gasatmosphäre geätzt wird, um Leitungsmuster, Elektroden und Kontakte zu erzeugen.

22. Ein Herstellungsverfahren für eine elektronische Komponente, in welchem ein metallischer Film aus einer hauptsächlich Cu umfassenden Legierung besteht, welche eine Zusammensetzung aus Mo in einer Menge von 0,1 bis 3,0 Gew.-%, einem oder mehreren Elementen, ausgewählt aus einer aus Al, Au, Ag, Ti, Ni, Co und Si bestehenden Gruppe, in einer Gesamtmenge von 0,1 bis 3,0 Gew.-% und Cu als Restgehalt besitzt, und ein anderer Film als der metallische Film mittels eines Ätzprozesses unter einer Gasatmosphäre, einschließlich Fluor, bearbeitet wird.

23. Eine elektronische optische Komponente mit Reflexionsschichten, Elektroden und Leitungsmustern, welche mittels eines metallischen Films, bestehend aus einer hauptsächlich Cu umfassenden Legierung, wobei der metallische Film aus einer Legierung mit einem Gehalt an Mo in einer Menge von 0,1 bis 3,0 Gew.-%, einem oder mehreren Elementen, ausgewählt aus der aus Al, Au, Ag, Ti, Ni, Co und Si bestehenden Gruppe, in einer Gesamtmenge von 0,1 bis 3,0 Gew.-% und Cu als Restgehalt besteht, erzeugt ist.

## Revendications

1. Matériau métallique pour un composant électronique, ledit matériau métallique se composant d'un alliage comprenant principalement du Cu et ayant une composition de Mo d'une quantité de 0,1 à 3,0 % en poids, d'une pluralité d'éléments sélectionnés dans un groupe composé d'Al, Au, Ag, Ti, Ni, Co et Si d'une quantité totale de 0,1 à 3,0 % en poids et de Cu en tant que teneur restante.

2. Matériau métallique pour un composant électronique selon la revendication 1, ledit matériau métallique ayant une résistance électrique inférieure à 10 µΩ cm.

3. Matériau métallique pour un composant électronique, ledit matériau métallique étant composé d'un alliage ternaire comprenant principalement du Cu, Mo d'une quantité de 0,1 à 3,0 % en poids et un élément sélectionné dans un groupe composé d'Al, Au, Ag, Ti, Ni, Co et Si d'une quantité de 0,1 à 3,0 % en poids.

4. Matériau métallique pour un composant électronique selon la revendication 3, ledit matériau métallique ayant une résistance électrique supérieure à 1,5 µΩ cm et inférieure à 7,0 µΩ cm.

5. Matériau métallique pour un composant électronique selon la revendication 1, ledit matériau métallique étant utilisé comme un matériau pour des motifs de câblage, des électrodes, des contacts et des cibles pour un processus de pulvérisation cathodique.

6. Composant électronique comportant des motifs de câblage, des électrodes et des contacts utilisant un matériau métallique, ledit matériau métallique étant composé d'un alliage comprenant principalement du Cu et ayant une composition de Mo d'une quantité de 0,1 à 3,0 % en poids, d'un ou d'une pluralité d'éléments sélectionnés dans un groupe composé d'Al, Au, Ag, Ti, Ni, Co et Si d'une quantité totale de 0,1 à 3,0 % en poids et de Cu en tant que teneur restante.

7. Composant électronique selon la revendication 6, ledit composant électrique présentant des motifs de câblage, des électrodes et des contacts qui sont formés par un processus de gravure en utilisant une solution comprenant de l'acide phosphorique et de l'acide nitrique.

8. Composant électronique selon la revendication 6, ledit composant électronique présentant des motifs de câblage, des électrodes et des contacts qui sont formés par un processus de gravure sous une atmosphère gazeuse comprenant du chlore.

9. Composant électronique selon l'une quelconque des revendications 6 à 8, ledit composant électronique comportant une région autre que celle dans laquelle des motifs de câblage, des électrodes et des contacts sont formés par un processus de gravure sous une atmosphère gazeuse comprenant du fluor.

10. Composant électronique selon l'une quelconque des revendications 6 à 9, ledit composant électronique présentant des motifs de câblage, des électrodes et des contacts qui sont formés par un traitement thermique dans la plage des températures allant de 100 °C à 750 °C.

11. Composant électronique selon l'une quelconque des revendications 6 à 10, ledit composant électronique présentant des motifs de câblage, des électrodes et des contacts qui sont formés sur une couche de support réalisée à partir d'un élément parmi Ti, W, Ta, Mo, oxyde d'indium-étain, nitrure de titane, oxyde de silicium et nitrure de silicium.

12. Composant électronique selon l'une quelconque des revendications 6 à 10, ledit composant électronique présentant des motifs de câblage, des électrodes et des contacts qui sont formés directement sur un substrat réalisé soit en verre, soit en résine plastique.

13. Dispositif électronique présentant des motifs de câblage, des électrodes et des contacts utilisant un matériau métallique, ledit matériau métallique étant composé d'un alliage comprenant principalement du Cu et ayant une composition de Mo d'une quantité de 0,1 à 3,0 % en poids, d'un ou d'une pluralité d'éléments sélectionnés dans un groupe composé d'Al, Au, Ag, Ti, Ni, Co et Si d'une quantité totale de 0,1 à 3,0 % en poids et de Cu en tant que teneur restante.

14. Dispositif électronique selon la revendication 13, ledit dispositif électronique présentant des motifs de câblage, des électrodes et des contacts qui sont formés par un processus de gravure en utilisant une solution comprenant de l'acide phosphorique et de l'acide nitrique.

15. Dispositif électronique selon la revendication 13, ledit dispositif électronique présentant des motifs de câblage, des électrodes et des contacts qui sont formés par un processus de gravure sous une atmosphère gazeuse comprenant du chlore.

16. Dispositif électronique selon la revendication 13, ledit dispositif électronique comportant une région autre que celle dans laquelle des motifs de câblage, des électrodes et des contacts sont formés par un processus de gravure sous une atmosphère gazeuse comprenant du fluor.

17. Dispositif électronique selon l'une quelconque des revendications 13 à 16, ledit dispositif électronique présentant des motifs de câblage, des électrodes et des contacts qui sont formés par un traitement thermique dans la plage des températures allant de 100 °C à 750 °C.

18. Dispositif électronique selon l'une quelconque des revendications 13 à 17, ledit dispositif électronique présentant des motifs de câblage, des électrodes et des contacts qui sont formés sur une couche de support réalisée à partir d'un élément parmi Ti, W, Ta, Mo, oxyde d'indium-étain, nitrure de titane, oxyde de silicium et nitrure de silicium.

19. Dispositif électronique selon l'une quelconque des revendications 13 à 17, ledit dispositif électronique présentant des motifs de câblage, des électrodes et des contacts qui sont formés directement sur un substrat réalisé soit en verre, soit en résine plastique.

20. Procédé de traitement d'un matériau métallique, dans lequel un film métallique composé d'un alliage comprenant principalement du Cu, ledit film métallique étant composé d'un alliage ayant une composition de Mo avec une quantité de 0,1 à 3,0 % en poids, d'un ou d'une pluralité d'éléments sélectionnés dans un groupe composé d'Al, Au, Ag, Ti, Ni, Co et Si d'une quantité totale de 0,1 à 3,0 % en poids et de Cu en tant que teneur restante, est gravé en utilisant une solution comprenant de l'acide phosphorique et de l'acide nitrique afin de former des motifs de câblage, des électrodes et des contacts.

21. Procédé de traitement d'un matériau métallique, dans lequel un film métallique composé d'un alliage comprenant principalement du Cu, ledit matériau métallique étant composé d'un alliage ayant une composition de Mo d'une quantité de 0,1 à 3,0 % en poids, d'un ou d'une pluralité d'éléments sélectionnés dans un groupe composé d'Al, Au, Ag, Ti, Ni, Co et Si d'une quantité totale de 0,1 à 3,0 % en poids et de Cu en tant que teneur restante, est gravé sous une atmosphère gazeuse comprenant de l'acide chlorhydrique afin de former des motifs de câblage, des électrodes et des contacts.

22. Procédé de fabrication d'un composant électronique, dans lequel un film métallique est composé d'un alliage comprenant principalement du Cu et ayant une composition de Mo d'une quantité de 0,1 à 3,0 % en poids, d'un ou d'une pluralité d'éléments sélectionnés dans un groupe composé d'Al, Au, Ag, Ti, Ni, Co et Si d'une quantité totale de 0,1 à 3,0 % en poids et de Cu en tant que teneur restante, et un film autre que ledit film métallique est traité par un processus de gravure sous une atmosphère gazeuse comprenant du fluor.

23. Composant optique électronique présentant des films réfléchissants, des électrodes et des motifs de câblage qui sont formés par un film métallique composé d'un alliage comprenant principalement du Cu, ledit film métallique étant composé d'un alliage ayant une teneur en Mo d'une quantité de 0,1 à 3,0 % en poids, d'un ou d'une pluralité d'éléments sélectionnés dans un groupe composé d'Al, Au, Ag, Ti, Ni, Co et Si d'une quantité totale de 0,1 à 3,0 % en poids et de Cu en tant que teneur restante.
